# EUROPEAN PATENT APPLICATION

(11) **EP 4 592 147 A1**
(43) Date of publication of application: **30.07.2025**
(21) Application number: 25154022.5
(22) Date of filing: 27.01.2025
(51) Int. Cl.: B60R 21/01, H02H 3/00, H02H 3/087, H02H 3/093, H02H 1/04, H02H 3/05

(54) **MULTI-CHANNEL TRIGGER SENSOR FOR PYROTECHNIC FUSES**

(30) Priority: 25.01.2024 US 202463624928 P; 02.07.2024 US 202463666777 P
(71) Applicant: Littelfuse, Inc., Rosemont, Illinois 60018 (US)
(72) Inventor: Hetzmannseder, Engelbert, Rosemont, 60018 (US); Mikstaite, Modesta, Rosemont, 60018 (US); Giraitis, Gintautas, Rosemont, 60018 (US)
(74) Representative: Arnold & Siedsma

(57) **Abstract**

Disclosed are multi-channel input trigger sensor (60) for pyrotechnic fuses. In some embodiments, the current sensor may include a multi-channel-input triggering pyrotechnic fuse (10) for electric vehicle (EV) applications, which is fast, reliable, and operates with different trigger sources and with different vehicle modes.
Fig. 3

## Description

### Cross-Reference to Related Application

This application claims priority to pending U.S. Provisional Patent Application No. 63/624,928, filed January 25, 2024, and U.S. Provisional Patent Application No. 63/666, 777, filed July 2, 2024.

### Field of the Disclosure

The present disclosure is generally related to the field of circuit protection devices. More particularly, the present disclosure relate to a multi-channel trigger sensor for a pyrotechnic fuse. The disclosure also relates to an electric vehicle, or electric vehicle application, comprising a multi-channel-input triggering pyrotechnic fuse, or fuse module, or the trigger sensor

### Background of the Disclosure

Fuses are commonly implemented in electrical systems for providing overcurrent protection. Most fuses are "passive" devices that include fuse elements that are configured to carry a rated amount of electrical current during normal operation. If current flowing through a fuse element exceeds the fuse element's rated current, the fuse element will melt, disintegrate, or otherwise separate, thereby arresting the current to prevent or mitigate damage to connected electrical components.

In some cases, it may be desirable to "actively" create a physical opening in an electrical circuit regardless of an amount of electrical current flowing through the circuit. For example, if an automobile is involved in a collision, it may be desirable to physically open an electrical circuit in the automobile to ensure that connected electrical components are deenergized to mitigate the risk of fire and/or electrocution in the aftermath of the collision. To that end, so-called pyrotechnic interrupters (PIs) have been developed which can be selectively actuated upon the occurrence of specified events to interrupt the flow of current in a circuit. For example, in the case of an automobile collision, a controller (e.g., an airbag control unit, battery management system, etc.) may send an initiation signal to a PI, causing a pyrotechnic ignitor within the PI to be detonated. A resultant increase in pressure within the PI rapidly forces a piston or blade to cut through a conductor that extends through the PI. Electrical current flowing through the PI is thereby interrupted, and the piston, which is formed of a dielectric material, provides an electrically insulating barrier between separated portions of the conductor to prevent electrical arcing therebetween.

In certain applications, it may be desirable to provide a multi-channel trigger sensor for a pyrotechnic fuse. It is with respect to these and other considerations that the present improvements may be useful.

### Summary of the Disclosure

The Summary is provided to introduce a selection of concepts in a simplified form, the concepts further described below in the Detailed Description. The Summary is not intended to identify key features or essential features of the claimed subject matter, nor is the Summary intended as an aid in determining the scope of the claimed subject matter.

In one approach, a current sensor may include a multi-channel-input triggering pyrotechnic fuse for electric vehicle (EV) applications, which is fast, reliable, and operates with different trigger sources and different vehicle modes.

In another approach, a trigger sensor operable with a fuse module may include a programable logic device and a diagnostics microcontroller unit operable to receive outputs from a hall sensor and one or more external sources, and to provide an output to a fuse module. The trigger sensor may further include a plurality of mode switching sources in communication with the programable logic device and a diagnostics microcontroller unit, wherein the programable logic device and a diagnostics microcontroller unit determine a vehicle operation mode from a plurality of vehicle operation modes.

In another approach, a multi-channel-input triggering pyrotechnic fuse for electric vehicle (EV) applications may include a programable logic device and a diagnostics microcontroller unit operable to receive outputs from a hall sensor and one or more external sources, and to provide an output to a fuse module. The multi-channel-input triggering pyrotechnic fuse for EV applications may further include a plurality of mode switching sources in communication with the programable logic device and a diagnostics microcontroller unit, wherein the programable logic device and a diagnostics microcontroller unit determine a vehicle operation mode from a plurality of vehicle operation modes.

In another approach, a multi-channel-input triggering pyrotechnic fuse for electric vehicle (EV) applications may include a programable logic device and a diagnostics microcontroller unit operable to receive outputs from a hall sensor and one or more external sources, and to provide an output to a fuse module. The multi-channel-input triggering pyrotechnic fuse for EV applications may further include a plurality of mode switching sources in communication with the programable logic device and a diagnostics microcontroller unit, wherein the programable logic device and a diagnostics microcontroller unit determine a vehicle operation mode from a plurality of vehicle operation modes, and wherein the programable logic device and the diagnostics microcontroller unit determine a over current detection response time.

The disclosure also relates to an electric vehicle, or electric vehicle application, comprising a multi-channel-input triggering pyrotechnic fuse, or fuse module, or the trigger sensor.

### Brief Description of the Drawings

The accompanying drawings illustrate exemplary approaches of the disclosure. wherein:
FIG. 1 depicts a perspective view of an active/passive fuse module according to the present disclosure;
**FIG. 2** is a circuit diagram of the active/passive fuse module of FIG. 1 including a multi-channel input trigger sensor, according to the present disclosure; and
**FIG. 3** is a circuit diagram of the active/passive fuse module of FIG. 1 including a multi-channel input trigger sensor, according to the present disclosure.

The drawings are not necessarily to scale. The drawings are merely representations, not intended to portray specific parameters of the disclosure. The drawings are intended to depict exemples of the disclosure, and therefore are not to be considered as limiting in scope. In the drawings, like numbering represents like elements.

Furthermore, certain elements in some of the figures may be omitted, or illustrated not-to-scale, for illustrative clarity. The cross-sectional views may be in the form of "slices", or "near-sighted" cross-sectional views, omitting certain background lines otherwise visible in a "true" cross-sectional view, for illustrative clarity. Furthermore, for clarity, some reference numbers may be omitted in certain drawings.

### Detailed Description

Assemblies, devices, systems, and methods in accordance with the present disclosure will now be described more fully hereinafter with reference to the accompanying drawings..

The present disclosure is directed to a multi-channel-input triggering pyrotechnic fuse for electric vehicle (EV) applications, which is fast, reliable, and operates with different trigger sources. In some cases, triggering may occur within fractions of a millisecond to ensure current limiting, hence protecting the HV system including the battery. To increase reliability, the trigger sensor may encompass diagnostics including in-range supply voltage, loss of ground, Hall IC internal diagnostics, and squib resistance diagnostics such as resistance measurement and short / open detection, such as low current (e.g., 50 mA) periodic (e.g., 10 ms) pulse to evaluate the resistance. The result of all these diagnostics is continuously communicated to the EV's battery management system (BMS) or engine control unit (ECU) via digital communication bus, pulse width modulation (PWM) output, or other customer-selected means.

As will be described in greater detail herein, different trigger sources allow protection based on current trigger (or internal trigger) internally to the trigger sensor via a built-in current sensor that triggers the pyrotechnic fuse as soon as a certain, predetermined level is exceeded, i.e., higher than the maximum current in any driving or charging conditions. Different trigger sources may further allow protection externally from, e.g., a squib drive, wherein the squib drive may be part of the BMS, which can be controlled via a controller area network (CAN) bus by the ECU, e.g., in case of a crash when the battery needs to be disconnected regardless of the current level. In yet other examples, triggering via the system's main current sensor (or sensors) via its OCD output may be used. It will be recognized that one or more combinations of the above are possible, although an external, non-current dependent trigger will often be used in most cases.

The present disclosure further provides false trigger avoidance by ignoring short current spikes that might not be caused by the busbar current itself, e.g., in the case of a lightning-generated EMI pulse, which ensures that power supply voltage is stable and within an acceptable level. Otherwise triggering functionality is disabled.

It will be understood that more than one pyrotechnic squib can be connected in parallel and triggered in parallel, i.e., at the same time. The pyrotechnic squibs will also be diagnosed, e.g., if all are OK, or at least one is not OK.

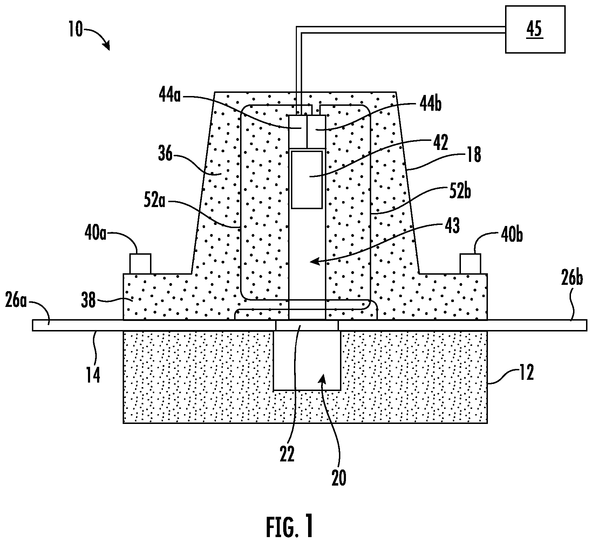

Referring to **FIG. 1****,** a cross-sectional view illustrating an active/passive fuse module 10 (hereinafter "the fuse module 10") in accordance with the present disclosure is shown. The fuse module 10 may generally include a base 12, a busbar 14, and a pyrotechnic interrupter (PI) 18. The base 12 may be formed electrically insulating material, such as plastic, polymer, ceramic, etc. The present disclosure is not limited in this regard. The base 12 may include a cavity 20 formed in a top surface thereof.

The busbar 14 may be formed from a single piece or length of conductive material (e.g., stamped from a single sheet of copper or the like) and may include a fuse element 22 and first and second terminal portions 26a, 26b extending from opposite ends of the fuse element 22. The busbar 14 may be disposed on the top surface of the base 12 in a horizontal orientation with the fuse element 22 extending over the cavity 20. The first and second terminal portions 26a, 26b may extend outside of, or beyond, the sides of the base 12 for facilitating connection of the fuse module 10 within a circuit.

The fuse element 22 may be configured to melt, disintegrate, or otherwise open if current flowing through the busbar 14 exceeds a predetermined threshold, or "current rating," of the fuse module 10. In various examples, the fuse element 22 may include perforations, slots, thinned or narrowed segments, and/or various other features for making the fuse element 22 more susceptible to melting or opening than other portions of the busbar 14. In a non-limiting example, the fuse element 22 may be configured to have a current rating in a range between 30 amps and 1000 amps. The present disclosure is not limited in this regard.

The PI 18 may include a housing 36 having a mounting flange 38 projecting from a lower portion thereof. The housing 36 may be disposed atop the base 12 with mechanical fasteners 40a, 40b extending through the mounting flange 38 and into the base 12 for fastening the components together in a vertically stacked relationship. The housing 36 may include a hollow, vertically oriented shaft 43 extending therethrough. The shaft 43 may have an open bottom end located directly above the fuse element 22 and the cavity 20.

The housing 36 may contain a movable piston or blade 42 (hereinafter "the piston 42") disposed within a hollow shaft 43 located above the cavity 20 of the base 12. The housing 36 may further contain one or more pyrotechnic ignitors 44 disposed within the shaft 43 above the piston 42.

Because the fuse element 22 begins to separate (e.g., melts) before the pyrotechnic ignitor 44 detonates and drives the piston 42, the fuse element 22 is weakened (e.g., partially melted) before the piston 42 is driven therethrough, making it easier for the piston 42 to cut through the fuse element 22. Thus, the fuse element 22 may be thicker/larger (and therefore capable of handling higher currents) than would be possible if the piston 42 were required to break through an unweakened portion of the busbar 14 (i.e., a portion of the busbar 14 other than the partially melted fuse element 22) as in conventional fuse modules incorporating pyrotechnic interrupters.

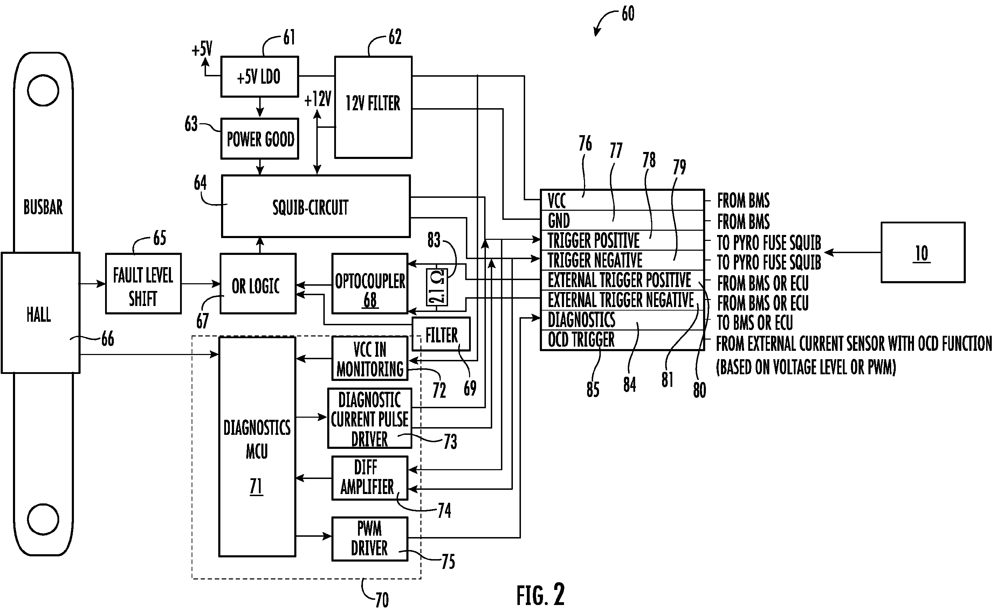

**FIG. 2** demonstrates that the fuse module 10 is operable with a current sensor 60. The current sensor 60 may be triggered via self-triggering by current level measurement, triggered via external signal from a squib drive, and triggered via an external signal from an over current detection (OCD) signal from another current sensor. More specifically, the current sensor 60 may be a multi-channel current sensor operable to receive outputs from a hall sensor 66 and one or more external sources, and to provide an output to the fuse module 10 via a trigger positive terminal 78 and a trigger negative terminal 79. The pyrotechnic ignitor 44 may be connected between the trigger positive terminal 78 and the trigger negative terminal 79. More specifically, the signal to activate the ignitor 44 may be sent from the current sensor 60 terminals, trigger positive terminal 78 and trigger negative terminal 79.

As shown, the current sensor 60 may include a low-dropout (LDO) voltage regulator 61 in communication with a filter (e.g., 12V) 62 and a power-good detector 63. The filter 62 and the power-good detector 63 may be in communication with a squib circuit 64. As further shown, the current sensor 60 may include a fault level shift device 65 in communication with a hall sensor 66 of the fuse module 10 and OR logic device 67. The OR logic device 67 may be in communication with the squib circuit 64, an optocoupler 68, and a second filter 69. The hall sensor 66 may be a coreless Hall sensor for very fast pyrotechnic triggering and smaller form factor.

As further shown, the current sensor 60 may include a diagnostics system 70 including a diagnostics microcontroller unit (MCU) 71 in communication with a Vcc monitor 72, a diagnostic current pulse driver 73, a differential amplifier 74, and a pulse width modulation (PWM) driver circuit 75. The diagnostics system 70 may be optional, with the primary function(s) of the current sensor 60 still being possible. That is, the current sensor 60 may be fully analog.

Vcc 76 is connected between the EV's BMS, the filter 62, and Vcc monitor 72, ground (GND) 77 is connected between the EV's BMS and filter 62, and trigger positive 78 and trigger negative 79 are connected between the pyrotechnic fuse squib and the squib circuit 64. As further shown, external trigger positive 80 and external trigger negative 81 are connected between BMS or ECU and optocoupler 68. A resistor 83 (e.g., 2.1 ohm) may be connected between the external trigger positive 80 and the external trigger negative 81. As further shown, diagnostics 84 is connected between BMS or ECU and the PWM driver 75, and OCD trigger 85 is connected between an external current sensor with OCD function (e.g., based on voltage level or PWM) and the filter 69.

During operation, the current sensor 60 may accommodate multiple inputs, e.g., from the internal sensor 66, from the external squib drive, or from the external current sensor (PWM or voltage level). For example, triggering may result from OR functionality with the three inputs, while AND functionality may also possible (e.g., two together for safety).

The current sensor 60 may further provide igniter emulation functionality for external trigger input. For example, the optocoupler 68 may provide galvanic isolation and a bidirectional current input from external trigger positive 80 and external trigger negative 81. This igniter resistance emulation further provides squib driver compatibility.

The current sensor 60 also provides diagnostics based on discrete electronic components (analog + diagnostics MCU 71). Low-end MCU monitoring of multiple signals allows for different diagnostic algorithms and customizable prioritization. For example, algorithms may combine information about squib's resistance, power supply voltage, and Hall diagnostics, while the PWM output signal allows for automatically diagnosing loss of ground via pull-up resistor. Resistance measurement may be implemented via low amplitude current pulses and a differential amplifier, and voltage level shift may be aligned to different circuits (MCU at 5 V vs. circuit at 12 V).

As mentioned above, the current sensor 60 advantageously provides analog sensing and triggering architecture, which increases the speed from the time current is exceeded to trigger signal (e.g., trigger positive 78) going to squib of the pyrotechnic fuse. The only digital may be for MCU 71 of the diagnostics system 70. In some cases, the igniter driver is based on discrete components, while false triggering avoidance by power supply monitoring (power good detector 63) triggering functionality is disabled until power is stable. False triggering avoidance by glitch filtering (e.g., second filter 69) is also provided, while extra filtering from filter 62 may protect from power supply voltage spikes.

As a result, faster response may be achieved as compared to conventional squib drivers, and a power bank for short power supply drops (capacitor usage for power storage) may be provided. Furthermore, a high-current output via fully opening the MOSFETs (achieved by using additional MOSFET drivers) may be possible, as is ability to drive and diagnose two igniters in parallel.

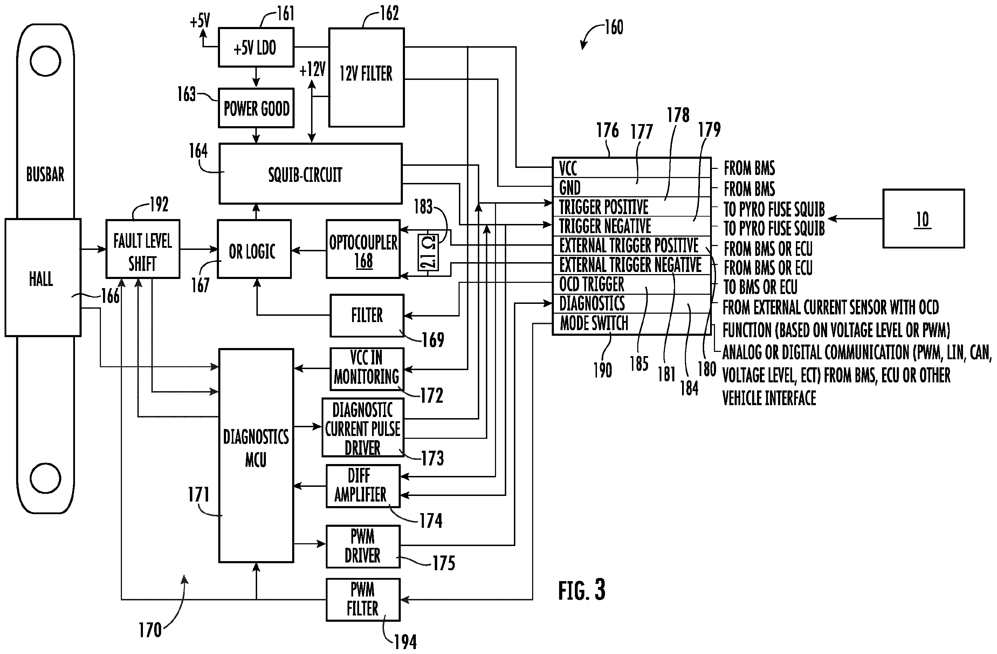

**FIG. 3** demonstrates that the fuse module 10 is operable with another current sensor 160. The current sensor 160 may be similar in some aspects to the current sensor 60 described above. As such, only certain aspects of current sensor 160 will be described hereinafter for the sake of brevity. The current sensor 160 may be triggered via self-triggering by current level measurement, triggered via external signal from a squib drive, and triggered via an external signal from an over current detection (OCD) signal from another current sensor. More specifically, the current sensor 160 may be a multi-channel current sensor operable to receive outputs from a hall sensor 166 and one or more external sources, and to provide an output to the fuse module 10 via a trigger positive terminal 178 and a trigger negative terminal 179. The pyrotechnic ignitor 144 may be connected between the trigger positive terminal 178 and the trigger negative terminal 179. More specifically, the signal to activate the ignitor 144 may be sent from the current sensor 160 terminals, trigger positive terminal 178 and trigger negative terminal 179.

As shown, the current sensor 160 may include a low-dropout (LDO) voltage regulator 161 in communication with a filter (e.g., 12V) 162 and a power-good detector 163. The filter 162 and the power-good detector 163 may be in communication with a squib circuit 164. As further shown, the current sensor 160 may include an internal programable logic device (PLD) 192 in communication with the hall sensor 166 of the fuse module 10 and OR logic device 167, wherein the PLD 192 states measurement to perform diagnostics on selected OCD delay mode. The OR logic device 167 may be in communication with the squib circuit 164, an optocoupler 168, and a second filter 169. The hall sensor 166 may be a coreless Hall sensor for very fast pyrotechnic triggering and smaller form factor.

As further shown, the current sensor 160 may include a diagnostics system 170 including a diagnostics microcontroller unit (MCU) 71 in communication with a Vcc monitor 172, a diagnostic current pulse driver 173, a differential amplifier 174, a pulse width modulation (PWM) driver circuit 175, and a PWM filter 194. Tthe diagnostics system 170 may be optional, with the primary function(s) of the current sensor 160 still being possible. That is, the current sensor 160 may be fully analog.

Vcc 176 is connected between the EV's BMS, the filter 162, and Vcc monitor 172, ground (GND) 177 is connected between the EV's BMS and filter 162, and trigger positive 178 and trigger negative 179 are connected between the pyrotechnic fuse squib and the squib circuit 164. As further shown, external trigger positive 180 and external trigger negative 181 are connected between BMS or ECU and optocoupler 168. A resistor 183 (e.g., 2.1 ohm) may be connected between the external trigger positive 180 and the external trigger negative 181. As further shown, diagnostics 184 is connected between BMS or ECU and the PWM driver 175, and OCD trigger 185 is connected between an external current sensor with OCD function (e.g., based on voltage level or PWM) and the filter 169.

During operation, the current sensor 160 may accommodate multiple inputs, e.g., from the internal sensor 166, from the external squib drive, or from the external current sensor (PWM or voltage level). For example, triggering may result from OR functionality with the three inputs, while AND functionality may also possible (e.g., two together for safety).

The current sensor 160 may further provide igniter emulation functionality for external trigger input. For example, the optocoupler 168 may provide galvanic isolation and a bidirectional current input from external trigger positive 180 and external trigger negative 181. This igniter resistance emulation further provides squib driver compatibility.

The current sensor 160 also provides diagnostics based on discrete electronic components (analog + diagnostics MCU 171). Low-end MCU monitoring of multiple signals allows for different diagnostic algorithms and customizable prioritization. For example, algorithms may combine information about squib's resistance, power supply voltage, and Hall diagnostics, while the PWM output signal allows for automatically diagnosing loss of ground via pull-up resistor. Resistance measurement may be implemented via low amplitude current pulses and a differential amplifier, and voltage level shift may be aligned to different circuits (MCU at 5 V vs. circuit at 12 V).

As mentioned above, the current sensor 160 advantageously provides analog sensing and triggering architecture, which increases the speed from the time current is exceeded to trigger signal (e.g., trigger positive 718) going to squib of the pyrotechnic fuse. The only digital may be for MCU 171 of the diagnostics system 170. In some cases, the igniter driver is based on discrete components, while false triggering avoidance by power supply monitoring (power good detector 163) triggering functionality is disabled until power is stable. False triggering avoidance by glitch filtering (e.g., second filter 169) is also provided, while extra filtering from filter 162 may protect from power supply voltage spikes.

As a result, faster response may be achieved as compared to conventional squib drivers, and a power bank for short power supply drops (capacitor usage for power storage) may be provided. Furthermore, a high-current output via fully opening the MOSFETs (achieved by using additional MOSFET drivers) may be possible, as is ability to drive and diagnose two igniters in parallel.

As further shown, the current sensor 160 may include a mode switch 190 to accommodate for several vehicle operation modes, e.g., driving, charging, accelerating, etc., as different operating modes may be beneficial to address different OCD response times. For example, longer response time in driving mode helps to avoid false triggering due to peripheries failures. The mode switch may be connected to the PMW filter 194, the diagnostics MCU 171, and the PLD 192. During use, to determine and verify a mode switch event, input signal measurements from the PLD 192 and the MCU 171 are combined. This increases robustness of the mode switch event.

The mode switch 190 provides an additional input to detect the mode being requested, which will dictate the current delay time, i.e., how much time the current is permitted to be above the threshold. A dedicated response time for each operational mode is possible, as and the response times can be switched during vehicle operation by different mechanisms, such as via received external communication request. Furthermore, response times modes can be configurable, e.g., based on internally measured current direction. Different triggering level values can be used for each current polarity. This provides a significant advantage over prior art options in which the pyro trigger has the same OCD triggering time for both current directions and all vehicle operation modes.

More specifically, multiple response time OCD delay configuration is possible for two (2) and more different delay options, for example, but not limited to 10us, 100us, 1ms, 10ms, etc. Furthermore, the mode switch 190 may provide current polarity-based OCD response time delay selection, as well as current polarity detection internally within the sensor. Although non-limiting, the switch mode 190 may permit external communication command-based OCD delay mode switching, for example, but not limited to, PWM, local interconnect networking (LIN), controller area network (CAN), voltage level, etc.

In sum, the disclosure provides a novel approach protect the electric vehicle HV circuit, wherein the sensor activates pyrotechnic fuse(s) by using different input trigger sources and switching based on vehicle mode(s), and by providing a reliable, very fast high current signal to the igniter.

As used herein, an element or step recited in the singular and proceeded with the word "a" or "an" is understood as not excluding plural elements or steps, unless such exclusion is explicitly recited.

The use of "including," "comprising," or "having" and variations thereof herein is meant to encompass the items listed thereafter and equivalents thereof as well as additional items. Accordingly, the terms "including," "comprising," or "having" and variations thereof are open-ended expressions and can be used interchangeably herein.

The phrases "at least one", "one or more", and "and/or", as used herein, are open-ended expressions and are both conjunctive and disjunctive in operation. For example, expressions "at least one of A, B and C", "at least one of A, B, or C", "one or more of A, B, and C", "one or more of A, B, or C" and "A, B, and/or C" means A alone, B alone, C alone, A and B together, A and C together, B and C together, or A, B and C together.

All directional references (e.g., proximal, distal, upper, lower, upward, downward, left, right, lateral, longitudinal, front, back, top, bottom, above, below, vertical, horizontal, radial, axial, clockwise, and counterclockwise) are just used for identification purposes to aid the reader's understanding of the present disclosure. The directional references do not create limitations, particularly as to the position, orientation, or use of the disclosure. Connection references (e.g., attached, coupled, connected, and joined) are to be construed broadly and may include intermediate members between a collection of elements and relative movement between elements unless otherwise indicated. As such, connection references do not necessarily infer two elements are directly connected and in fixed relation to each other.

Furthermore, identification references (e.g., primary, secondary, first, second, third, fourth, etc.) are not intended to connote importance or priority, and are used to distinguish one feature from another. The drawings are for purposes of illustration, and the dimensions, positions, order and relative sizes reflected in the drawings attached hereto may vary.

## Claims

1. A trigger sensor operable with a fuse or a fusemodule, the trigger sensor comprising:
a programable logic device and a diagnostics microcontroller unit operable to receive outputs from a hall sensor and one or more external sources, and to provide an output to a fuse module; and
a plurality of mode switching sources in communication with the programable logic device and the diagnostics microcontroller unit, wherein the programable logic device and the diagnostics microcontroller unit determine a vehicle operation mode from a plurality of vehicle operation modes.

2. The trigger sensor of claim 1, wherein the programable logic device and the diagnostics microcontroller unit determine an over current detection response time based on the determined vehicle operation mode.

3. The trigger sensor of claim 1, wherein the programmable logic device and the diagnostics microcontroller unit determine an over current detection response time based on an internally measured current polarity of a current.

4. The trigger sensor of claim 3, wherein the over current detection response time is an amount of delay the current is permitted to be above a threshold value.

5. The trigger sensor of claim 3 or 4, wherein the over current detection response time is switch between multiple, different over current detection response times based on the internally measured current polarity of the current and without an external mode switch signal.

6. The trigger sensor of any of the preceding claims, further comprising a pulse width modulation filter connected to the plurality of mode switching sources.

7. The trigger sensor of claim 6, wherein the pulse width modulation filter is further connected to the diagnostics microcontroller unit and to the programable logic device.

8. The trigger sensor of any of the preceding claims, wherein the trigger sensor is operable to trip a fuse of the fuse module in response to at least one of the following: a current level measurement exceeding a predefined threshold, an external signal from a squib drive, and an external signal from another current sensor indicating an over current.

9. A multi-channel-input triggering pyrotechnic fuse or fuse module, comprising a trigger sensor according to any of the preceding claims.

10. The multi-channel-input triggering pyrotechnic fuse or fuse module of claim 9, further comprising a resistor.

11. The multi-channel-input triggering pyrotechnic fuse or fuse module according to claim 10, wherein the resistor has a same resistance as a pyro ignitor used to imitate an ignitor for external triggering from the squib drive.

12. The multi-channel-input triggering pyrotechnic fuse or fuse module of claim 10 or 11, further comprising an optocoupler component.

13. The multi-channel-input triggering pyrotechnic fuse or fuse module according to claim 12, wherein the optocoupler component is externally triggerable from the squib drive.

14. An electric vehicle, or electric vehicle application, comprising a multi-channel-input triggering pyrotechnic fuse or fuse module, according to any of the claims 9-12 or a trigger sensor according to any of the claims 1-8.

15. Use of a multi-channel-input triggering pyrotechnic fuse or fuse module, according to any of the claims 9-12 or a trigger sensor according to any of the claims 1-8 in an electric vehicle or in an electric vehicle application.
